# EUROPEAN PATENT SPECIFICATION

(11) **EP 0 449 539 B1**
(45) Date of publication and mention of the grant of the patent: **03.07.1996**
(21) Application number: 91302554.0
(22) Date of filing: 25.03.1991
(51) Int. Cl.: H01L 29/772, H01L 29/43

(54) **Ohmic contact for thin film transistor**
Ohmscher Kontakt-Dünnschichttransistor
Contact ohmique pour transistor couche mince

(30) Priority: 27.03.1990 JP 77385/90; 15.08.1990 JP 215491/90
(43) Date of publication of application: 02.10.1991
(73) Proprietor: KABUSHIKI KAISHA TOSHIBA, Kawasaki-shi, Kanagawa-ken 210 (JP)
(72) Inventor: Hiramatsu, Masato, c/o Intell. Property Division, Minato-ku, Tokyo 105 (JP); Kamimura, Takaaki, c/o Intell. Property Division, Minato-ku, Tokyo 105 (JP); Nakajima, Mitsuo, c/o Intell. Property Division, Minato-ku, Tokyo 105 (JP)
(74) Representative: Freed, Arthur Woolf

(56) References cited:
- EP-A- 0 342 796
- PATENT ABSTRACTS OF JAPAN vol. 13, no. 264 (E-774) 19 June 1989 ; & JP-A-01 057 755
- PATENT ABSTRACTS OF JAPAN vol. 9, no. 81 (E-307)(1804) 10 April 1985 ; & JP-A-59 213 169
- PATENT ABSTRACTS OF JAPAN vol. 14, no. 179 (P-1034) 10 April 1990 ; & JP-A-02 028 624
- PATENT ABSTRACTS OF JAPAN vol. 11, no. 17 (E-471) 17 January 1987 ; & JP-A-61 188 969
- PATENT ABSTRACTS OF JAPAN vol. 11, no. 400 (E-569) 26 December 1987 ; & JP-A-62 160 769
- PATENT ABSTRACTS OF JAPAN vol. 9, no. 169 (E-328)(1892) 13 July 1985 ; & JP-A-60 43 869

## Description

The present invention relates to a thin film transistor using a silicon active layer.

Since display elements such as electroluminescence, a light-emitting diode, a plasma, fluorescence, and a liquid crystal can provide flat panel type display devices, these devices have been demanded to be applied as special-purpose display devices such as terminal display devices of measuring instruments, office machines, and computers. Of these devices, an electroluminescent or liquid crystal display device using a switching element matrix array consisting of thin film transistors has received a great deal of attention as a display device having low power consumption and low cost.

As materials of these switching transistors, single-crystalline, polycrystalline, and amorphous Si, CdSe, Te, CdS, and the like are used. Since a thin film technique in a low-temperature process can be applied to a polycrystalline semiconductor and an amorphous semiconductor of these materials, an active matrix element consisting of switching transistors can be formed on even a substrate as of glass required to be treated at a relatively low temperature, and a large, inexpensive display device has been available.

A thin film transistor (TFT) of this type is described in a literature, e.g., Published Unexamined Japanses Patent Application No. 102560/83.

In the above conventional TFT, amorphous silicon (a-Si) films serving as an active layer and an ohmic contact layer cannot be continuously formed because the steps of forming and patterning a protection film (contributing to an etching process for forming source and drain electrodes separated each other) interrupt this. As a result, when the protection film is patterned, the active layer is also etched, and a junction between the active layer and the ohmic contact layer is degraded. Thus, good ohmic contact cannot be obtained, and the TFT characteristics are degraded.

In addition, when an active layer and an ohmic contact layer are continously formed without interposing a protection film therebetween, and the ohmic contact layer is patterned, the active layer is required to have a large film thickness because the active layer is etched when the ohmic contact layer is patterned. For this reason, a process for forming the films requires a long time, or the TFT is always set in an ON state. Therefore, the reproductibility of the TFT characteristics is degraded, and productivity and a yield of products are decreased.

Other similar known TFT structures are described in Patent Abstracts of Japan vol. 13, No. 264 which corresponds to the preamble of claim 1, and JP-A-1 57 755, Patent Abstracts of Japan vol. 4, No. 81, and JP-A-59 88 008 and Patent Abstracts of Japan vol. 14, No. 179 and JP-A-2 28 624.

As described above, in the first-mentioned conventional TFT, the active layer and the ohmic contact layer cannot be continously formed,and the active layer is damaged when the protection film is formed. Therefore, perfect ohmic contact is difficult to be obtained between the active layer and the ohmic contact layer, thereby degrading the TFT characteristics.

The present invention has been made in consideration of the above problem, and has as its object to provide a thin film transistor in which a contact resistance between an active layer and an ohmic contact layer is decreased, and TFT characteristics and mass-productivity are improved.

In order to achieve the above object, the present invention provides a thin film transistor comprising:
a silicon active layer including source and drain regions and a channel region formed between and connecting the source and drain regions;
source and drain ohmic contact layers separated from each other and corresponding to the source and drain regions, respectively;
source and drain electrodes contacting source and drain ohmic contact layers, respectively; and
a gate electrode arranged opposite the channel region of the active layer with a gate insulating film interposed therebetween;
wherein an electrically conductive auxiliary film consisting of a silicon film doped with nitrogen intervenes between and contacts the active layer and each of the source and drain ohmic contact layers, the auxiliary film being formed on surfaces of the source, channel and drain regions of the active layer; and
the nitrogen concentration in the auxiliary film has a distribution in the direction of film thickness such that the nitrogen concentration is continuously reduced toward the active layer over the entirety of the film thickness.

According to a preferred aspect of the present invention, the active layer is formed by micro crystalline silicon or amorphous silicon. A nitrogen concentration of the auxiliary film means may be 10¹⁸ to 10¹⁹ atoms/cc. An additional auxiliary film means may have the same composition as that of the auxiliary film means and may be formed in a surface of a channel region of the active layer and integrated with the auxiliary film means in the source and drain regions of the active layer.

A structure according to the present invention can be applied to inverted stagger, stagger, and coplanar transistors.

According to the thin film transistor of the present invention, since an active layer has an auxiliary film means, the etching resistance of the active layer can be improved without causing a decrease in electric conductivity. As a result, since damage to the surface of the active layer caused by an etching process for a protection film and source and drain electrodes is smaller than that of the conventional technique, a good junction state between the active layer and an ohmic contact layer can be obtained, thereby improving TFT characteristics.

This invention can be more fully understood from the following detailed description when taken in conjunction with the accompanying drawings, in which:
Fig. 1 is a sectional view showing a thin film transistor according to the first embodiment of the present invention;
Figs. 2A to 2E are sectional views showing the steps in manufacturing the thin film transistor shown in Fig. 1;
Fig. 3 is a graph showing a relationship between a time required to form the thin transistor shown in Fig. 1 and a flow rate of source gas;
Fig. 4 is a graph showing a nitrogen concentration in the thin film transistor shown in Fig. 1;
Fig. 5 is a graph showing a nitrogen concentration in a thin film transistor according to the second embodiment of the present invention;
Figs. 6A to 6E are sectional views showing the steps in manufacturing a thin film transistor according to the third embodiment of the present invention;
Fig. 7 is a graph showing etching rates of a nitrogen-doped a-Si film and an n⁺-type a-Si film as a function of a flow ratio of CF₄;
Fig. 8 is a sectional view showing a thin film transistor according to the fourth embodiment of the present invention; and
Fig. 9 is a sectional view showing a coplanar thin film transistor according to the fifth embodiment of the present invention.

An embodiment of the present invention will be described below with reference to the accompanying drawings.

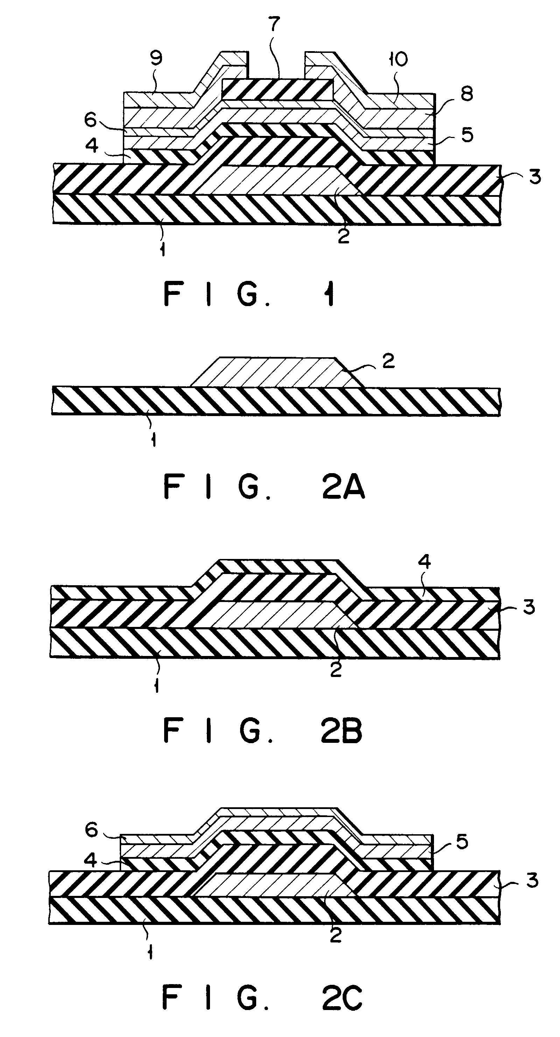

Fig. 1 is a sectional view showing a thin film transistor according to the first embodiment of the present invention.

A gate electrode 2 having a thickness of 200 nm and made of a Ta film or an MoTa alloy film is formed on a light-transmitting insulating substrate 1 made of a glass substrate. A silicon oxide film 3 serving as a first gate insulating film and having a thickness of about 300 nm is formed on the substrate 1 to cover the gate electrode 2. In addition, a silicon nitride film 4 serving as a second gate insulating film is formed on the silicon oxide film 3 to have a thickness of about 50 nm. An undoped a-Si film 5 having a thickness of about 50 nm and formed as an active layer by a photo CVD method and a nitrogen doped a-Si film 6 (nitrogen concentration 1 × 10¹⁸ atoms/cc) formed by adding ammonia gas to a source gas are sequentially formed on the silicon nitride film 4. A silicon nitride film serving as a protection film 7 and having a thickness of about 100 nm is formed on the surface of the nitrogen doped a-Si film 6 on the gate electrode 2. A multi-layered drain electrode 10 and a multi-layered source electrode 9 each consisting of Aℓ and Mo films and each having a thickness of about 1 µm are formed on the nitrogen doped a-Si film 6 to have a predetermined distance therebetween. n+-type a-Si films 8 serving as ohmic contact layers and each having a thickness of about 50 nm are formed between the source electrode 9 and the nitrogen doped a-Si film 6 and between the drain electrode 10 and the nitrogen doped a-Si film 6 by a plasma CVD method or the like.

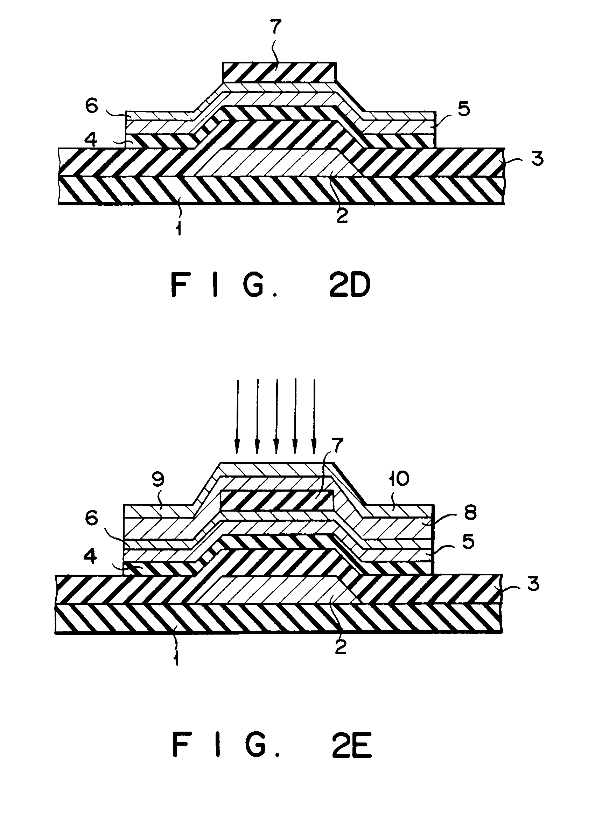

Figs. 2A to 2E are views showing steps in manufacturing the thin film transistor. Fig. 2A shows the step of forming the gate electrode 2 on the substrate 1, Fig. 2B shows the step of forming the silicon oxide film 3 and the silicon nitride film 4 serving as gate insulating films, Fig. 2C shows the step of forming the undoped a-Si film 5 and the nitrogen doped a-Si film 6 serving as active layers, Fig. 2D shows the step of patterning the protection film 7, and Fig. 2E shows the step of sputtering an electrode metal layer made of Mo and Al films and patterning it to form the source and drain electrodes 9 and 10.

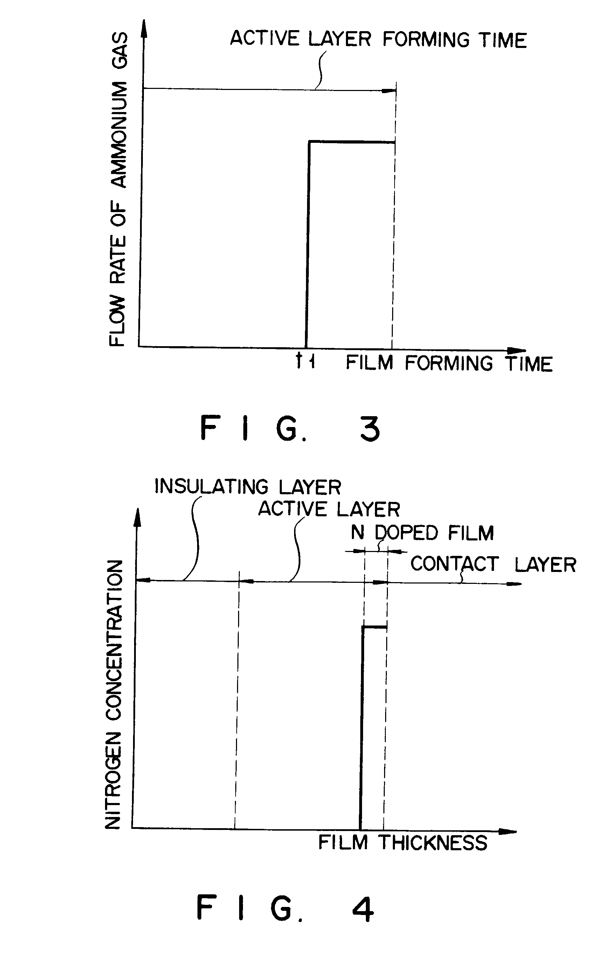

As shown in Fig. 3, in the above manufacturing steps, the nitrogen doped a-Si film 6 is formed by supplying ammonia gas to a reaction chamber at a predetermined flow rate from time t₁ when the undoped a-Si film 5 is formed to have a thickness of about 50 nm. As shown in Fig. 4, when a nitrogen concentration in these layers was evaluated, it was confirmed that the nitrogen doped a-Si film 6 containing nitrogen having a predetermined concentration was formed. According to an experiment performed by the present inventors, when a nitrogen concentration exceeded 1 × 10²⁰ atoms/cc the a-Si film was rapidly changed into an insulating film. However, it was confirmed that an a-Si film having a nitrogen concentration of about 5 × 10¹⁷ to 5 × 10¹⁹ atoms/cc effectively decreased the contact resistance. In addition, it was confirmed that the contact resistance was decreased when a nitrogen concentration near the interface between the active layer and the ohmic contact layer was high, even if the thickness of the nitrogen doped a-Si film 6 was decreased.

When the undoped a-Si film 5 and the nitrogen doped a-Si film 6 were formed by a photo CVD method and a plasma CVD method, interface characteristics could be improved by the photo CVD method, since, unlike by the plasma CVD method, no damage caused by charged particles occurred in the interface between the undoped a-Si film 5 and the nitrogen doped a-Si film 6. Therefore, it was confirmed that the field effect mobility of a TFT was increased.

In the thin film transistor with the above structure, since electric contacts between the active layer and the source electrode 9 and between the active layer and the drain electrode 10 are improved compared with a conventional structure, excellent TFT characteristics can be obtained.

A thin film transistor according to the second embodiment of the present invention will be described below. In this embodiment, unlike in the first embodiment described above, an active layer is formed using micro crystalline silicon (µc-Si) as a material in place of a-Si. Therefore, since the active layer has the same sectional shape as that of the first embodiment in Fig. 1, a description thereof will be made with reference to Fig. 1.

This embodiment will be described below in accordance with its manufacturing steps. A gate electrode 2 is formed using a metal film such as an MoTa or MoTaCu alloy film having a thickness of about 250 nm on a light-transmitting insulating substrate 1 made of a glass substrate. A silicon oxide film 3 having a thickness of about 250 nm and serving as a first gate insulating film is formed by a thermal CVD method to cover the gate electrode 2. In addition, a silicon oxide film 4 having a thickness of about 50 nm and serving as a second gate insulating film, a micro crystal silicon film 5 (µc-Si film) having a thickness of about 50 nm and serving as an active layer, and a nitrogen doped a-Si film 6 (nitrogen concentration 1× 10¹⁸ atoms/cc) having a thickness of about 10 nm are sequentially formed. A silicon nitride film having a thickness of about 100 nm and serving as a protection film 7 is formed on the nitrogen doped a-Si film 6. The above insulating film 4, the µc-Si film 5, and the nitrogen doped a-Si film 6 are formed by a plasma CVD method or a photo CVD method. The photo CVD method is preferably used for forming the µc-Si film 5 and the nitrogen doped a-Si film 6.

The protection film 7 is patterned to expose a part of the nitrogen doped a-Si film 6. Thereafter, an n⁺-type a-Si film 8 having a thickness of about 50 nm and serving as an ohmic contact layer is formed by, e.g., a plasma CVD method. In addition, a CrAℓ alloy film having a thickness of about 1 µm is formed on the n⁺-type a-Si film 8 by sputtering and is patterned to form source and drain electrodes 9 and 10, thereby obtaining an TFT.

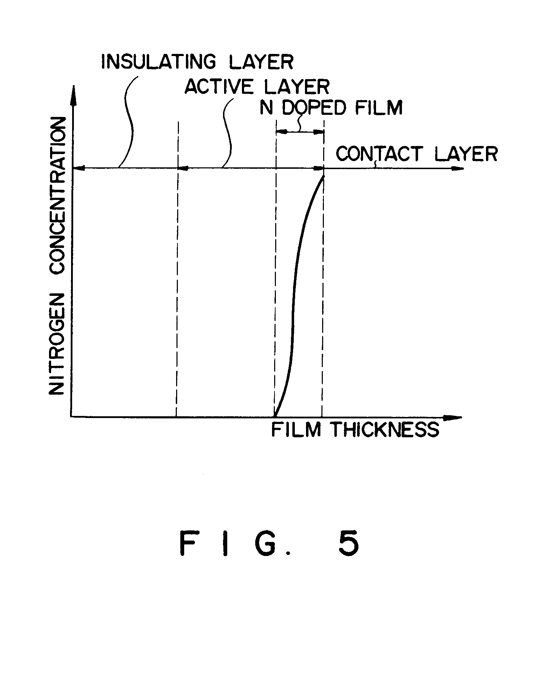

Note that a nitrogen concentration in the nitrogen doped a-Si film 6 has a concentration distribution in direction of film thickness as shown in Fig. 5.

In the thin film transistor with the above arrangement, since a µc-Si film having an electron mobility larger than that of an a-Si film is used, ohmic contact characteristics are improved, and the field effect mobility of the TFT is greatly increased.

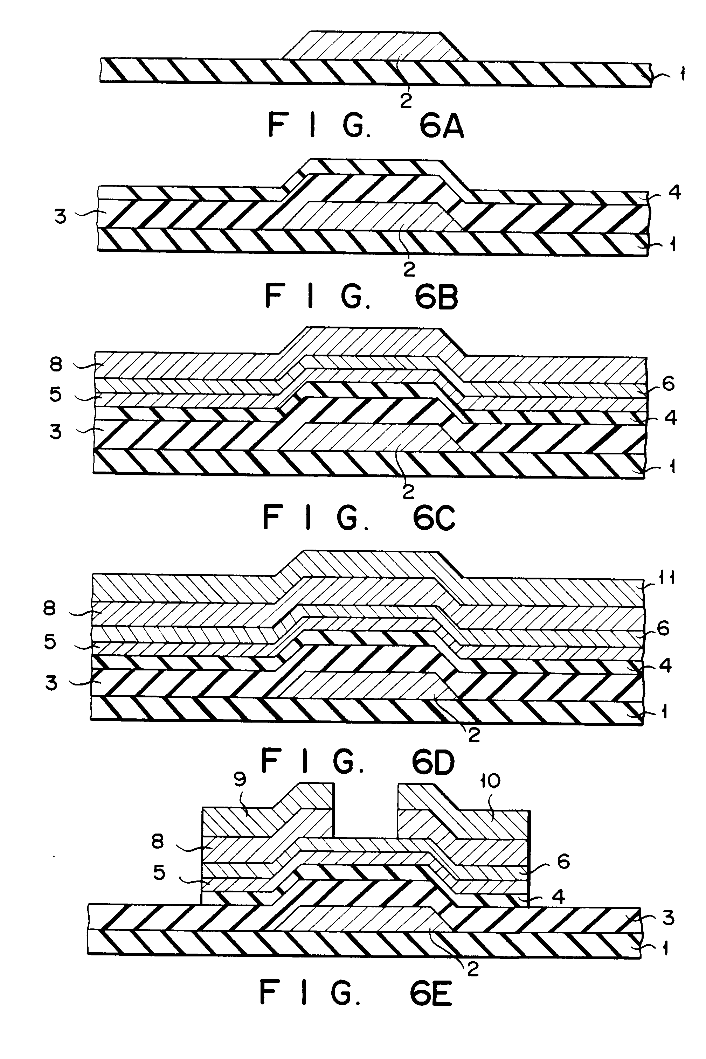

Figs. 6A to 6E are sectional views showing steps in manufacturing a thin film transistor according to the third embodiment of the present invention. The same reference numerals as in Fig. 1 denote the same parts in Figs. 6A to 6E, and a detailed description thereof will be omitted.

In this embodiment, unlike in the first embodiment described above, no silicon nitride film serving as the protection film 7 is formed, an undoped a-Si film 5, a nitrogen doped a-Si film 6, and an n⁺-type a-Si film 8 are sequentially formed, and the n⁺-type a-Si film 8 is patterned using the nitrogen doped a-Si film 6 as an etching protection film.

This embodiment will be described in accordance with the manufacturing steps. First, a gate electrode 2 is formed on a light-transmitting insulating film 1 using a metal film made of an MoTa or MoTaCu alloy and having a thickness of about 250 nm.

As shown in Fig. 6B, a silicon oxide film 3 having a thickness of about 250 nm and a nitrogen silicon film 4 having a thickness of about 50 nm are sequentially formed on the substrate 1 on which the gate electrode 2 is formed.

As shown in Fig. 6C, an undoped a-Si film 5 serving as an active layer and having a thickness of about 50 nm and a nitrogen doped a-Si film 6 (nitrogen concentration 1 × 10¹⁸ atoms/cc) having a thickness of about 10 nm are formed on the nitrogen silicon film 4 using a plasma CVD method or a photo CVD method. Thereafter, an n⁺-type a-Si film 8 serving as an ohmic contract layer and having a thickness of about 50 nm is formed on the nitrogen doped a-Si film 6 using the plasma CVD method. Note that, as in the first embodiment, the nitrogen doped a-Si film 6 is formed such that a predetermined amount of ammonia gas is supplied to a reaction chamber from a timing at which the thickness of the undoped a-Si film 5 becomes about 50 nm.

As shown in Fig. 6D, a multi-layered metal film 11 consisting of an Mo film having a thickness of about 50 nm and an Aℓ film having a thickness of about 1 µm is formed on the n⁺-type a-Si film 8 using sputtering.

As shown in Fig. 6E, finally, the multi-layered metal film 11 and the n⁺-type a-Si film 8 are patterned by a microwave excitation etching device to form source and drain electrodes 9 and 10, thereby obtaining a thin film transistor. Note that the etching is performed under the following conditions. That is, CF₄ gas at a flow rate of 200 SCCM and O₂ gas at a flow rate of 50 SCCM are used as etching gases, a pressure of 30 Pa is held in an etching chamber, and the microwave has a power of 600 w.

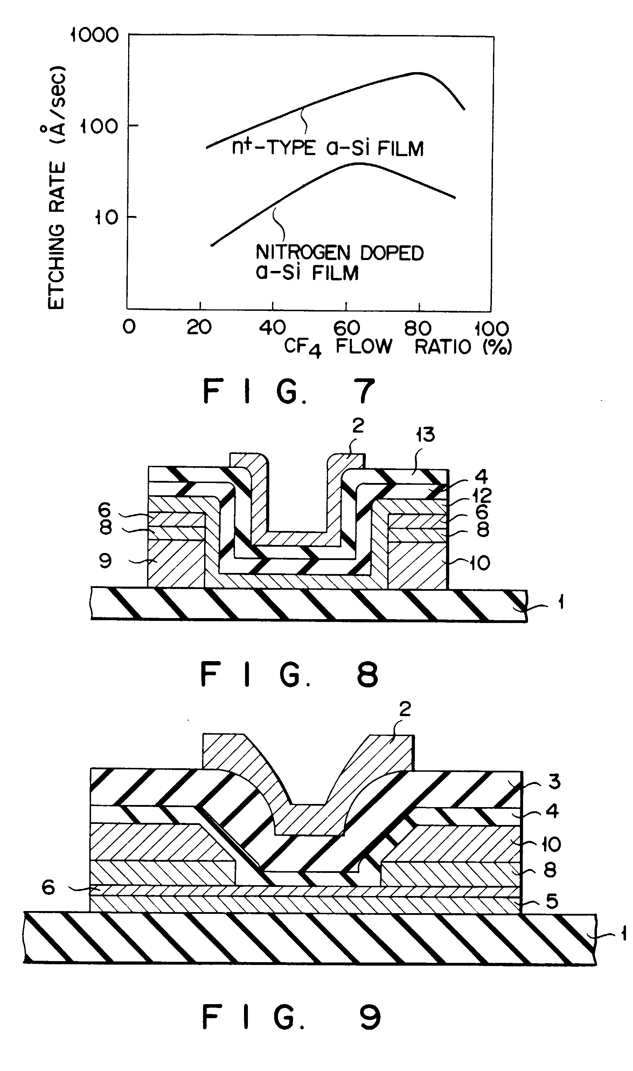

Fig. 7 is a graph showing the etching rates of the nitrogen doped a-Si film 6 and the n⁺-type a-Si film 8 as a function of the percentage of the flow rate of the CF₄ gas with respect to the total flow rate (250 SCCM) of the etching gas. As is apparent from the graph, when the percentage of the flow rate of the CF₄ gas is 80%, i.e., the flow rate of the CF₄ gas is 200 SCCM, a ratio of the etching rate of n⁺-type a-Si film 8 to that of the nitrogen doped a-Si film 6 is about 10.

In the thin film transistor with the above arrangement, since an etching ratio of the n⁺-type a-Si film 8 to the nitrogen doped a-Si film 6 can be set to be high, the nitrogen doped a-Si film 6 is used as a protection film. As a result, the undoped a-Si film 5 can be formed to be thin, and a time required for forming the film 5 can be shortened. In addition, unlike a prior art or the first embodiment, the protection film 7 need not be formed, and the number of steps of etching can be reduced, thereby improving massproducitivity.

Since the undoped a-Si film 5, the nitrogen doped a-Si film 6, and the n⁺-type a-Si film 8 are formed by a continuous deposition step, the interfaces thereof can be covered to be clean, the contact between the undoped a-Si film 5 and the nitrogen doped a-Si film 6 and the contact between the nitrogen doped a-Si film 6 and the n⁺-type Si film 8 can be satisfactory.

Fig. 8 is a sectional view showing a thin film transistor according to the fourth embodiment of the present invention. In this embodiment, the present invention is applied to a stagger thin film transistor. The embodiment will be described below in accordance with the manufacturing steps.

A CrAℓ alloy film having a thickness of about 1 µm is formed by vacuum deposition on a light-transmitting insulating substrate 1 made of a glass substrate. An a-Si film 8 serving as an ohmic contact layer and having a thickness of about 50 nm and a nitrogen doped a-Si film 6 (nitrogen concentration 1 × 10¹⁸ atoms/cc) having a thickness of about 10 nm are sequentially formed on the CrAℓ alloy film using a plasma CVD method, and these films are patterned to form source and drain electrodes 9 and 10. A polysilicon film 12 serving as an active layer is formed to have a thickness of 250 nm. In addition, a silicon oxide film 3 serving as a second insulating film and having a thickness of about 50 nm is formed, and a tantalum oxide film 13 serving as an insulating film and having a thickness of about 100 nm is formed. A metal film made of Mo or the like and having a thickness of about 250 nm is formed by sputtering. Finally, the metal film is patterned to form a gate electrode 2, thereby completing a TFT.

In the stagger thin film transistor with the above structure, it was confirmed that the ohmic contact layers between the source electrode 9 and the active layer and between the drain electrode 10 and the active layer were largely improved as compared with a conventional structure, and the transistor had excellent TFT characteristics.

The present invention is not limited to the above embodiments. The present invention can be applied not only to the inverted stagger TFTs of the first to third embodiments and to the stagger TFT of the fourth embodiment but to the coplanar TFT. A structure obtained by applying the arrangement and the manufacturing method of the present invention to a coplanar TFT is shown in Fig. 9. The reference numerals as in Fig. 1 denote the same parts in Fig. 9. An insulating film used in this embodiment may be made of silicon carbide or the like.

As described above, according to the present invention, since the nitrogen doped a-Si film and the ohmic contact layer in the active layer are bonded to each other, the contact resistance can be decreased, and a time required for forming the films can be shortened. Therefore, mass production of highly reliable thin film transistor can be performed.

According to the method of manufacturing the above thin film transistor, since nitrogen is contained in non-single-crystalline silicon to decrease the etching resistance of a non-single-crystalline film, a junction state between a non-single-crystalline silicon film and an ohmic contact layer, and TFT characteristics can be improved. In addition, the non-single-crystalline silicon film to the ohmic contact layer can be continuously formed without causing any disadvantage such that the TFT is always set in an ON state due to an increase in thickness of the non-single-crystalline silicon film. Therefore, the steps of forming and patterning a protection film can be omitted, and the state of the interface between the non-single-crystalline silicon film containing nitrogen and the contact layer can be improved, thereby improving reliability and mass-productivity of TFTs.

## Claims

1. A thin film transistor comprising:
a silicon active layer (5) including source and drain regions and a channel region formed between and connecting the source and drain regions;
source and drain ohmic contact layers (8) separated from each other and corresponding to the source and drain regions, respectively;
source and drain electrodes (9, 10) contacting source and drain ohmic contact layers, respectively; and
a gate electrode (2) arranged opposite the channel region of the active layer with a gate insulating film (3, 4) interposed therebetween;
an electrically conductive auxiliary film (6) consisting of a silicon film doped with nitrogen which intervenes between and contacts the active layer and each of the source and drain ohmic contact layers, the auxiliary film being formed on surfaces of the source and drain regions of the active layer;
characterised in that said auxiliary film is furthermore formed or the channel region of said active layer; and
the nitrogen concentration in the auxiliary film has a distribution in the direction of film thickness that the nitrogen concentration is continuously reduced toward the active layer over the entirety of the film thickness.

2. A transistor according to claim 1, further characterised by comprising a protection film (7) formed on part of the surface of the auxiliary film (6) corresponding to the channel region.

3. A transistor according to claim 2, further characterised in that the protection film (7) comprises a silicon nitride film.

4. A transistor according to claims 2 to 3, further characterised in that the source and drain ohmic contact layers (8) each have extensional portions which extend and terminate on the protection film (7) such that respective ends of the extensional portions face each other on the protection film (7).

5. A transistor according to claim 4, further characterised in that the source and drain electrodes (9, 10) each have ends aligned with the ends of the extensional portions of the source and drain ohmic contact layers (8), respectively, and facing each other on the protection film.

6. A transistor according to any one of claims 1 to 5, further characterised in that the nitrogen concentration in the auxiliary film (6) is from 5 x 10¹⁷ atoms/cc to 1 x 10²⁰ atoms/cc.

7. A transistor according to claim 6, further characterised in that the nitrogen concentration in the auxiliary film (6) is from 5 x 10¹⁷ atoms/cc to 5 x 10¹⁹, atoms/cc.

8. A transistor according to any one of claims 1 to 7, further characterised in that the gate insulating film comprises a silicon oxide film (3) contacting the gate electrode and a silicon nitride film (4) contacting the active layer (5, 12).

9. A transistor according to any one of claims 1 to 8, further characterised by being an inverted stagger transistor.

10. A method of manufacturing a transistor according to any one of claims 1 to 9, characterised in that said active layer (5, 12) and auxiliary film is sequentially formed by a chemical vapour deposition method in which ammonia gas is supplied to a reaction chamber to form said auxiliary film (6) after said active layer (5, 12) has been formed so as to have a predetermined thickness.

11. A method according to claim 10, further characterised in that said chemical vapour deposition method is a photo-chemical vapour deposition method.

## Patentansprüche

1. Dünnfilmtransistor mit:
einer Siliziumaktivschicht (5) mit Source- und Drainbereichen sowie einem Kanalbereich, der dazwischen gebildet ist und die Source- und Drainbereiche verbindet,
ohmschen Source- und Drainkontaktschichten (8), die voneinander beabstandet sind und jeweils den Source- und Drainbereichen entsprechen,
Source- und Drainelektroden (9, 10), die jeweils die ohmschen Source- und Drainkontaktschichten kontaktieren und
einer Gateelektrode (2), die gegenüber zu dem Kanalbereich der Aktivschicht angeordnet ist, wobei ein Gateisolierfilm (3, 4) dazwischen gelegen ist,
einem elektrisch leitenden Hilfsfilm (6), der aus einem mit Stickstoff dotierten Siliziumfilm besteht, welcher zwischen der Aktivschicht und jeder der ohmschen Source- und Drainkontaktschichten liegt und diese kontaktiert, wobei der Hilfsfilm auf Oberflächen der Source- und Drainbereiche der Aktivschicht gebildet ist,
dadurch gekennzeichnet, daß
der Hilfsfilm weiterhin auf dem Kanalbereich der Aktivschicht gebildet ist, und
die Stickstoffkonzentration in dem Hilfsfilm eine Verteilung in der Richtung der Filmdicke aufweist derart, daß die Stickstoffkonzentration kontinuierlich zu der Aktivschicht über der Gesamtheit der Filmdicke verringert ist.

2. Transistor nach Anspruch 1, weiterhin gekennzeichnet durch einen Schutzfilm (7), der auf einem Teil der Oberfläche des Hilfsfilmes (6) entsprechend dem Kanalbereich gebildet ist.

3. Transistor nach Anspruch 2, weiterhin dadurch gekennzeichnet, daß der Schutzfilm (7) einen Siliziumnitridfilm umfaßt.

4. Transistor nach den Ansprüchen 2 und 3, weiterhin dadurch gekennzeichnet, daß die ohmschen Source- und Drainkontaktschichten (8) jeweils Ausdehnungsteile haben, die sich auf dem Schutzfilm (7) erstrecken und derart enden, daß jeweilige Enden der Ausdehnungsteile einander auf dem Schutzfilm (7) gegenüberliegen.

5. Transistor nach Anspruch 4, weiterhin dadurch gekennzeichnet, daß die Source- und Drainelektroden (9, 10) jeweils Enden haben, die mit den Enden der Ausdehnungsteile jeweils der ohmschen Source- und Drainkontaktschichten (8) ausgerichtet sind und die einander auf dem Schutzfilm gegenüberliegen.

6. Transistor nach einem der Ansprüche 1 bis 5, weiterhin dadurch gekennzeichnet, daß die Stickstoffkonzentration in dem Hilfsfilm (6) von 5 x 10¹⁷ Atome/cm³ bis 1 x 10²⁰ Atome/cm³ reicht.

7. Transistor nach Anspruch 6, weiterhin dadurch gekennzeichnet, daß die Stickstoffkonzentration in dem Hilfsfilm (6) von 5 x 10¹⁷ Atomen/cm³ bis 5 x 10¹⁹ Atomen/cm³ reicht.

8. Transistor nach einem der Ansprüche 1 bis 7, weiterhin dadurch gekennzeichnet, daß der Gateisolierfilm einen Siliziumoxidfilm (3), der die Gateelektrode kontaktiert, und einen Siliziumnitridfilm (4), der die Aktivschicht (5, 12) kontaktiert, umfaßt.

9. Transistor nach einem der Ansprüche 1 bis 8, weiterhin gekennzeichnet durch einen invertierten Staffeltransistor.

10. Verfahren zum Herstellen eines Transistors nach einem der Ansprüche 1 bis 9, dadurch gekennzeichnet, daß die Aktivschicht (5, 12) und ein Hilfsfilm sequentiell durch ein chemisches Dampfabscheidungsverfahren gebildet werden, bei dem Ammoniakgas zu einer Reaktionskammer gespeist ist, um den Hilfsfilm (6) zu bilden, nachdem die Aktivschicht (5, 12) gebildet wurde, um eine vorbestimmte Dicke zu haben.

11. Verfahren nach Anspruch 10, weiterhin dadurch gekennzeichnet, daß das chemische Dampfabscheidungsverfahren ein photo-chemisches Dampfabscheidungsverfahren ist.

## Revendications

1. Transistor à couches minces comportant:
une couche active de sil;cium (5) incluant une région source et une région drain et une région canal formée entre la région source et la région drain et les reliant;
des couches (8), à contact ohmique avec la source et avec le drain, séparées l'une de l'autre et correspondant à la région source et à la région drain, respectivement;
des électrodes source et drain (9, 10) venant en contact avec les couches à contact ohmique avec la source et avec le drain, respectivement; et
une électrode grille (2) disposée en face de la région canal de la couche active, avec une couche (3, 4) d'isolement de la grille interposée entre elles;
une couche auxiliaire électriquement conductrice (6) constituée d'une couche de silicium dopé à l'azote qui s'interpose entre, et vient en contact avec, la couche active et chacune des couches à contact ohmique avec la source et avec le drain, la couche auxiliaire étant formée sur des surfaces de la région source et de la région drain de la couche active;
caractérisé par le fait que ladite couche auxiliaire est en outre formée sur la région canal de la dite couche active; et
que la concentration en azote dans la couche auxiliaire présente, dans la direction de l'épaisseur de la couche, une distribution telle que la concentration en azote se réduit de façon continue en direction de la couche active sur la totalité de l'épaisseur du film.

2. Transistor selon la revendication 1, caractérisé en outre par le fait qu'il comporte une couche de protection (7) formée sur une partie de la surface de la couche auxiliaire (6) correspondant à la région canal.

3. Transistor selon la revendication 2, caractérisé en outre en ce que la couche de protection (7) comporte une couche de nitrure de silicium.

4. Transistor selon les revendications 2 à 3, caractérisé en outre en ce que les couches (8) à contact ohmique avec la source et avec le drain présentent chacune des portions en extension qui s'étendent et se terminent sur la couche de protection (7) de façon que les extrémités respectives des portions d'extension se fassent face l'une l'autre sur la couche de protection (7).

5. Transistor selon la revendication 4, caractérisé en outre par le fait que l'électrode source et l'électrode drain (9, 10) ont chacune des extrémités alignées avec les extrémités des portions en extension des couches (8) à contact ohmique avec la source et avec le drain, respectivement, et se faisant face l'une l'autre sur la couche de protection.

6. Transistor selon l'une quelconque des revendications 1 à 5, caractérisé en outre par le fait que la concentration en azote dans la couche auxiliaire (6) vaut de 5x10¹⁷ atomes/cm³ à 1x10²⁰ atomes /cm³.

7. Transistor selon la revendication 6, caractérisé en outre par le fait que la concentration en azote dans la couche auxiliaire (6) vaut de 5 x 10¹⁷ atomes/cm³ à 5 x 10¹⁹ atomes /cm³.

8. Transistor selon l'une quelconque des revendications 1 à 7, caractérisé en outre par le fait que la couche d'isolement de la grille comporte une couche d'oxyde de silicium (3) qui est en contact avec l'électrode grille et une couche de nitrure de silicium (4) qui est en contact avec la couche active (5, 12).

9. Transistor selon l'une quelconque des revendications 1 à 8, caractérisé en outre par le fait qu'il est un transistor décalé inverseur.

10. Procédé de fabrication d'un transistor conforme à une quelconque des revendications 1 à 9, caractérisé par le fait que l'on forme séquentiellement ladite couche active (5, 12) et ladite couche auxiliaire par un procédé de dépôt chimique en phase vapeur dans lequel on envoie du gaz ammoniac dans la chambre de réaction pour former ladite couche auxiliaire (6) après avoir formé ladite couche active (5, 12) jusqu'à ce qu'elle ait une épaisseur prédéterminée.

11. Procédé selon la revendication 10, caractérisé en outre par le fait que ledit procédé de dépôt chimique en phase vapeur est un procédé de dépôt photochimique en phase vapeur.
